Europäisches Patentamt

(19) European Patent Office

Office européen des brevets

(11) EP 0 932 057 B1

(12) FASCICULE DE BREVET EUROPEEN

(45) Date de publication et mention
de la délivrance du brevet:
**31.07.2002 Bulletin 2002/31**

(51) Int Cl.7: **G02B 5/18**, H01S 3/106,
H01S 3/08

(21) Numéro de dépôt: **99100969.7**

(22) Date de dépôt: **20.01.1999**

(54) **Dispositif de diffraction d'ondes lumineuses**

Lichtwellen diffraktierende Vorrichtung

Lightwave diffracting device

(84) Etats contractants désignés:
**CH DE ES FI FR GB IE IT LI NL SE**

(30) Priorité: **23.01.1998 EP 98101221
26.01.1998 EP 98101279**

(43) Date de publication de la demande:
**28.07.1999 Bulletin 1999/30**

(73) Titulaire: **Parriaux, Olivier M.
42100 Saint-Etienne (FR)**

(72) Inventeurs:
• **Tishchenko, Alexandre V.
15/356, Moscou 117311 (RU)**
• **Sychugov, Vladimir A.
Moscou 109088 (RU)**
• **Parriaux, Olivier M.
42100 Saint-Etienne (FR)**

(74) Mandataire: **Ravenel, Thierry Gérard Louis et al
I C B,
Ingénieurs Conseils en Brevets SA,
7, rue des Sors
2074 Marin (CH)**

(56) Documents cités:
• **SVAKHIN A S ET AL: "DIFFRACTION GRATINGS
WITH HIGH OPTICAL STRENGTH FOR LASER
RESONATORS" QUANTUM ELECTRONICS, vol.
24, no. 3, 1 mars 1994, pages 233-235,
XP000434434**

• **LOKTEV S M ET AL: "Reflection of a finite light
beam from a finite waveguide grating"
KVANTOVAYA ELEKTRONIKA, MOSKVA, MAY
1997, TURPION LTD.;KVANTOVAYA
ELEKTRONIKA, RUSSIA, vol. 24, no. 5, pages
457-461, XP002084336 ISSN 0368-7147**
• **SYCHUGOV V A ET AL: "OPTIMIZATION AND
CONTROL OF GRATING COUPLING TO OR
FROM A SILICON-BASED OPTICAL
WAVEGUIDE" OPTICAL ENGINEERING, vol. 35,
no. 11, novembre 1996, pages 3092-3099,
XP000638603**
• **A.S.SVAKHIN, V.A. SYCHUGOV, A.E.
TIKHOMIROV: 'Efficient diffraction elements for
TE-polarized waves' SOV. PHYS. TECH. PHYS.
vol. 36, no. 9, 1992, USSR, pages 1038 - 1040**
• **TIE-NAN DING, E. GARMIRE: 'Measuring
refractive index and thickness of thin films : a
new technique' APPLIED OPTICS vol. 22, no. 20,
15 Octobre 1983, USA, pages 3177 - 3181**
• **L.B. MASHEV, E.K. POPOV, E.G. LOWEN:
'Optimization of the grating efficiency in grazing
incidence' APPLIED OPTICS vol. 26, no. 22, 15
Novembre 1987, USA, pages 4738 - 4741**
• **R. REINISCH, G. VITRANT: 'Phase matching in
Cherenkov second-harmonic generation : a
leaky-mode analysis' OPTICS LETTERS vol. 22,
no. 11, 01 Juillet 1997, USA, pages 760 - 762**
• **R. ULRICH, W. PRETTL: 'planar leaky
ligth-guides and couplers' APPLIED PHYSICS 21
Septembre 1972, GERMANY, pages 55 - 68**

**Description**

La présente invention concerne un dispositif de diffraction d'ondes lumineuses. En particulier, l'invention concerne un tel dispositif formé par une couche, notamment diélectrique, dans laquelle peuvent se propager des ondes lumineuses, et présentant un réseau de diffraction agencé à une face de cette couche.

Des dispositifs de ce type ont été décrits récemment dans la littérature, en particulier par l'article "Diffraction gratings with high optical strength for laser resonators", Quantum Electronics, 24 (3), pages 233 à 235, 1994. Ce document décrit seulement une utilisation d'un dispositif du type susmentionné sous la condition particulière de Littrow, c'est-à-dire avec une onde diffractée d'ordre "-1" se propageant selon la direction de l'onde incidente avec un sens opposé. Une formulation analytique a été établie pour l'efficacité de diffraction selon l'ordre "-1". Cette formule a été établie avec la condition d'un réseau peu efficace.

Ce document mentionne que des efficacités élevées (environ 85%) peuvent être obtenues pour des angles d'incidence aux environs de 45°. Selon ce document, lorsque l'angle d'incidence θ (défini depuis la direction normale au réseau de diffraction) augmente, il est question d'une efficacité d'environ 60 % (θ = 68°). Pour des angles d'incidence plus grands encore, par exemple pour θ = 85°, il est mentionné que des calculs ont montré qu'il est possible de s'attendre à des efficacités allant jusqu'au 50 %.

Premièrement, on remarquera que le document susmentionné donne une formule analytique pour l'efficacité de diffraction qui est prétendue valable sous la condition particulière de Littrow pour un dispositif de diffraction du type mentionné précédemment. Ensuite, cette formule est établie pour des réseaux peu profonds pour ne prendre en considération que les rayons de lumière subissant un seul événement de diffraction. Ainsi, le domaine de validité d'une telle formule ne peut concerner que les faibles efficacités de diffraction.

Deuxièmement, sur la base du document susmentionné, l'homme du métier ne peut s'attendre à des efficacités de diffraction très élevées, lorsque l'angle d'incidence est grand, par exemple supérieur à 70°. Pour des angles d'incidence d'environ 85°, il ne s'attend pas à obtenir une efficacité supérieure à 50 % avec l'enseignement de l'art antérieur. Ainsi, avec une efficacité de diffraction ne dépassant pas 50 %, de nombreuses applications se voient privées d'avenir avec le dispositif de diffraction proposé.

Le document susmentionné fait référence à un autre document antérieur, au nom des mêmes auteurs, qui donne sensiblement la même formule analytique et un enseignement similaire.

On constate ainsi une absence d'enseignement pour des dispositifs de diffraction dont la direction de l'onde diffractée principale est différente de la direction d'incidence bien que cette situation soit favorable à de nombreuses applications. Ensuite, l'homme du métier qui modifierait la période spatiale du réseau de diffraction de manière à obtenir une telle situation pour la diffraction d'une onde incidente s'attend à une efficacité de diffraction relativement peu élevée, c'est-à-dire inférieure ou égale à 50 %, lorsque la direction d'incidence définit un angle relativement grand, c'est-à-dire proche de 90° par rapport à la direction normale au réseau de diffraction.

Troisièmement, l'homme du métier est conforté dans son préjugé lorsqu'il fait une première analyse classique sur les rayons réfléchis, réfractés et diffractés par une structure de diffraction du type dont il est question présentement. En effet, lors d'une analyse classique sur les différents rayons lumineux en présence, il s'aperçoit qu'avec un angle d'incidence aux environs de 45°, l'intensité de l'onde réfléchie initialement est d'un ordre comparable à l'intensité de l'onde transmise dans la couche diélectrique et à l'intensité de l'onde diffractée dans cette couche diélectrique selon l'ordre de diffraction "-1". Ainsi, l'homme du métier s'attend pour des angles d'incidence au environ de 45° à pouvoir compenser l'onde réfléchie par une interférence destructive avec l'onde transmise sortant à nouveau de la couche diélectrique et également avec la contribution de l'onde diffractée d'ordre "-1" dans la couche et ressortant de celle-ci également par diffraction dans la direction de l'onde réfléchie. Par contre, lorsque l'angle d'incidence augmente et devient relativement grand, c'est-à-dire qu'il s'approche de 90° et en particulier dans la situation d'une incidence rasante, l'intensité de l'onde réfléchie, relativement à l'intensité de l'onde transmise et à l'intensité de l'onde diffractée d'ordre "-1" dans la couche diélectrique, est très importante. Dans le cadre d'une telle analyse que fait généralement l'homme du métier pour orienter ses recherches, cet homme du métier reçoit a priori une confirmation du fait que l'efficacité de diffraction pour une faible incidence, notamment rasante est limitée.

Malgré la situation décrite ci-avant qui règne dans le domaine des dispositifs de diffraction optique avant la présente invention et le préjugé de l'homme du métier à concevoir de tels dispositions à haute efficacité pour une onde incidente rasante ou une onde diffractée d'ordre "-1" rasante, les inventeurs ont orienté leurs recherches dans cette direction en cherchant à déterminer dans quelle mesure la couche diélectrique, à la surface de laquelle est agencé le réseau de diffraction, peut être utilisée ou mise à contribution pour résoudre le problème de l'annulation de la forte intensité lumineuse réfléchie. Dans le cadre de ces recherches, ils ont abouti à utiliser la couche diélectrique comme guide d'ondes propageant un mode à fuite. Ils ont ainsi démontré qu'en déterminant correctement les paramètres caractéristiques du dispositif de diffraction objet de la présente invention, une résonance peut être engendrée dans la couche diélectrique et une onde de haute énergie peut ainsi se propager dans cette couche selon un mode à fuite correspondant. Grâce à l'excitation d'une résonance dans la couche diélectrique par une onde incidente de longueur d'onde et d'angle d'incidence donnés, il est possible d'accumuler suffisamment d'énergie dans cette couche pour que l'amplitude d'une onde sortant de cette couche dans la direction de réflexion présente une amplitude comparable à l'amplitude de l'onde réfléchie initialement et un déphasage de sensiblement $\pi$ permettant une interférence destructive. Ceci permet de diminuer l'intensité de l'onde réfléchie. L'ajustement des deux amplitudes à l'égalité est opéré par le réseau de diffraction qui permet donc une annulation de l'onde réfléchie. Pour ce faire, on détermine une profondeur spécifique de ce réseau de diffraction. Ainsi, l'intensité lumineuse renvoyée par le dispositif de diffraction se propage essentiellement selon les directions de diffraction. En sélectionnant correctement la période spatiale du réseau de diffraction, il est possible de limiter la diffraction à l'ordre "-1" hors de ce dispositif de diffraction. Ainsi, on obtient une très haute efficacité de diffraction, laquelle peut théoriquement être égale à 100 %.

L'invention a donc pour objet un dispositif de diffraction d'ondes lumineuses tel que défini à la revendication 1, lequel présente dans des modes de réalisation préférés les caractéristiques données aux revendications 2 à 11.

Grâce aux caractéristiques de l'objet de l'invention, il est possible d'obtenir de très hautes efficacités de diffraction en dehors de la situation correspondant à la condition de Littrow et à son voisinage, en particulier sous un angle d'incidence élevé. La solution de la présente invention ne permet pas a priori d'assurer une haute efficacité de diffraction sous la condition de Littrow et son voisinage étant donné qu'il y a une symétrie dans la couche diélectrique entre l'onde réfractée et l'onde diffractée d'ordre "-1". Ainsi, les conditions de la présente invention assurant une résonance dans la couche sur la base de l'onde réfractée engendrent également une résonance sur la base de l'onde diffractée dans cette couche. Dans cette situation particulière, nous sommes donc en présence de deux ondes à fuite se propageant dans la couche avec un sens opposé. De ce fait, dans les conditions retenues pour la présente invention, la situation particulière correspondant sensiblement à la condition de Littrow est éliminée. Les présents inventeurs n'ont pas fait actuellement de recherches particulières pour déterminer l'efficacité de diffraction envisageable sous la condition de Littrow et son voisinage.

L'effet de la présente invention est particulièrement étonnant dans un mode de réalisation préféré où l'angle d'incidence est supérieur à 80° et l'angle de diffraction est inférieur à cet angle d'incidence. Dans un cas particulièrement intéressant de ce mode de réalisation pour diverses applications, l'angle de diffraction est relativement petit et nettement inférieur à l'angle d'incidence. Pour éviter des pertes par diffraction d'ordre supérieur à 1, on choisit de préférence un réseau de diffraction définissant une direction de diffraction pour l'ordre "-1" avec un angle positif ou sensiblement égal à zéro étant entendu que l'angle d'incidence a une valeur positive.

Etant donné qu'il est possible d'obtenir de très hautes efficacités de diffraction approchant quasi 100 %, il est possible d'appliquer le théorème de réciprocité et d'utiliser le dispositif de diffraction selon l'invention avec une onde incidente présentant un angle d'incidence relativement peu élevé et une direction de diffraction définissant un angle de diffraction élevé, notamment supérieur à 80°. Toutefois, dans ce dernier cas, le modèle n'est pas réciproque dans le cas d'une onde incidente normale. Ainsi, selon un autre mode de réalisation préféré, le dispositif de diffraction est prévu dans une configuration avec un angle de diffraction supérieur à 80° et avec un angle d'incidence inférieur à cet angle de diffraction et supérieur à zéro, étant entendu que l'angle de diffraction a un signe positif.

La présente invention et diverses utilisations ou applications de celles-ci seront décrites ci-après à l'aide de la description suivante, faites en référence aux dessins annexés donnés à titre d'exemples, dans lesquels :

- la figure 1 représente schématiquement un dispositif de diffraction selon l'invention avec une onde incidente et les ondes engendrées par ce dispositif;
- la figure 2 décrit schématiquement selon une analyse classique divers rayons optiques en présence et leurs directions de manière à visualiser les ondes intervenant dans l'analyse de l'interaction entre une onde incidente et le dispositif de l'invention;
- la figure 3 est un schéma simplifié de la figure 2 mettant en évidence le concept qui est à la base de la présente invention;
- les figures 4 à 6 décrivent respectivement trois applications du dispositif selon l'invention; et
- la figure 7 décrit un laser, plus particulièrement sa cavité résonante au sein de laquelle le dispositif selon l'invention est introduit pour permettre une sélection de la longueur d'onde de l'onde résonante sans partie mobile.

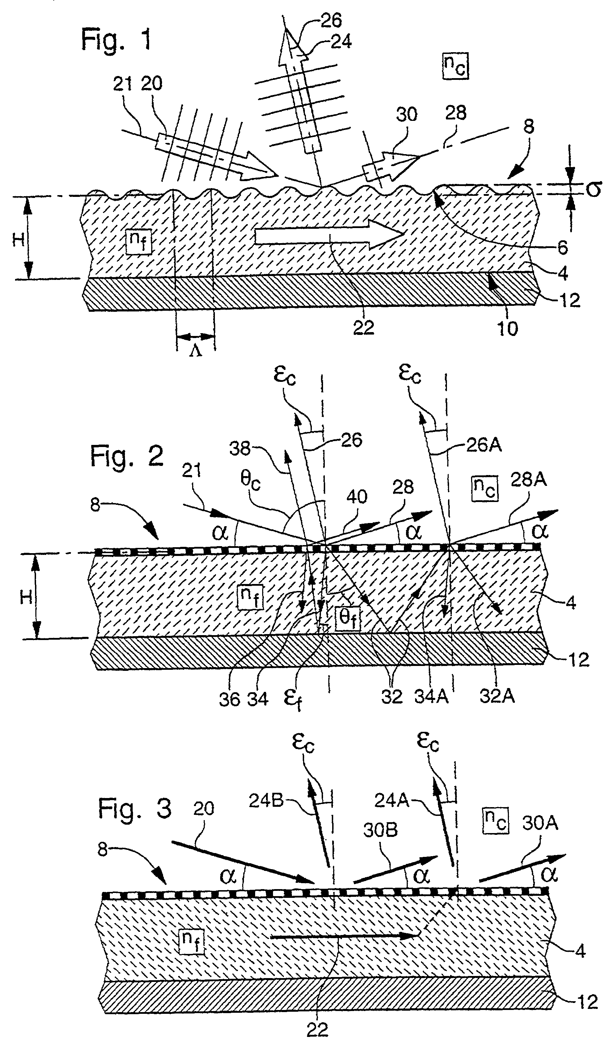

A l'aide des figures 1 à 3, on décrira ci-après le dispositif de diffraction selon l'invention et ses propriétés. Ce dispositif est formé d'une couche diélectrique 4 dans laquelle peuvent se propager des ondes lumineuses. A une face supérieure 6 de la couche 4 est prévu un réseau de diffraction 8. Ce réseau 8 présente une période spatiale $\Lambda$. Contre une face inférieure 10 de la couche 4 est agencée une structure réfléchissante 12.

L'onde incidente 20 a une longueur d'onde $\lambda$ déterminée et présente un angle d'incidence $\theta_c$, cet angle étant défini relativement à la direction normale au réseau de diffraction 8. Ainsi, l'angle $\alpha$ entre la direction d'incidence et le plan défini par le réseau de diffraction est égal à $\Pi/2 - \theta_c$. Les paramètres caractéristiques du dispositif, en particulier la hauteur moyenne H de la couche 4 et l'indice de réfraction nf de cette couche sont sélectionnés de manière que la couche 4 satisfasse sensiblement à la condition d'excitation d'un mode à fuite dans cette couche pour l'onde incidente 20 donnée. Ainsi, une onde 22 (ci-après nommée onde à fuite) se propage dans la couche 4 selon ledit mode à fuite lorsque l'onde incidente 20, ayant un angle d'incidence et une longueur d'onde prédéfinis, arrive sur le réseau de diffraction 8.

La période spatiale $\Lambda$ de ce réseau 8 est déterminée de manière à ce qu'une onde diffractée 24 d'ordre "-1" se propage selon une direction de diffraction 26 définissant un angle de diffraction $\varepsilon_c$ défini relativement à la direction normale au réseau 8. Selon la direction de réflexion 28, une onde réfléchie 30 de faible intensité se propage lorsque l'efficacité de diffraction n'est pas maximale. Selon un but de l'invention, il est prévu de diminuer fortement l'intensité de l'onde réfléchie 30, voir de la rendre nulle pour obtenir une très haute efficacité de diffraction dans la direction 26. La période spatiale $\Lambda$ du réseau 8 est déterminée de manière à ce que l'onde incidente 20 soit essentiellement diffractée selon la direction 26, c'est-à-dire selon l'ordre "-1" de diffraction. Comme le montrent les figures 1 à 3, le domaine de l'invention concerne les situations dans lesquelles la direction de diffraction 26 est différente de la direction d'incidence 21.

Sur la figure 2 sont représentés divers rayons géométriques correspondant à diverses ondes résultantes de la présence d'une onde incidente selon la direction d'incidence 21. L'analyse à l'aide de l'optique géométrique laisse apparaître trois événements déterminants dans la redistribution de l'énergie lumineuse dans le milieu de l'onde incidente.

Le premier événement se situe au point d'impact du rayon incident 21 (assimilé à la direction d'incidence). Le rayon incident 21 engendre un rayon réfléchi 28 (assimilé à la direction de réflexion), un rayon réfracté 32 se propageant dans la couche 4, un premier rayon diffracté 34 d'ordre "-1" se propageant également dans la couche 4 et un rayon diffracté 26 (assimilé à la direction de diffraction 26) se propageant dans le milieu du rayon incident 21 (milieu d'incidence).

Le deuxième événement concerne le point d'impact du rayon 34 diffracté sur le réseau 8 puis réfléchi par le miroir 12. Trois rayons optiques sont engendrés lors de ce deuxième événement. Il y a le rayon réfléchi 36, le rayon réfracté 38 et le rayon diffracté 40 d'ordre "-1". En particulier pour des profondeurs $\sigma$ du réseau 8 peu profondes, on s'attend à ce que le rayon réfracté 38 selon la direction de diffraction 26 soit prédominant, l'amplitude des rayons réfléchi et diffracté 36 et 40 étant alors faible. On notera qu'un réseau 8 de faible profondeur est particulièrement adapté à une incidence rasante ou plus généralement à des angles d'incidences $\theta_c$ relativement grands, par exemple supérieurs à 80°.

Le troisième événement est défini par l'impact du rayon réfracté 32 sur le réseau de diffraction 8 après que ce rayon réfracté 32 a subi une réflexion sur le miroir 12. Le rayon réfracté 32 arrivant sur le réseau 8 est optiquement équivalent au rayon d'incidence 21. Les rayons optiques engendrés sont donc les mêmes que ceux engendrés par le rayon incident 21. Ainsi sont engendrés un rayon réfracté 28a se propageant selon la direction de réflexion 28, un rayon réfléchi 32a se propageant dans la couche 4 et deux rayons de diffraction 26a et 34a d'ordre "-1".

Selon l'invention, il est prévu de déterminer les paramètres caractéristiques du dispositif de diffraction de manière à ce que les diverses contributions selon la direction de réflexion 28 s'annulent par interférence destructive. Comme déjà mentionné, l'amplitude de l'onde correspondant au rayon 40 est faible. Par contre, l'amplitude de l'onde réfléchie correspondant au rayon optique 28 présente une amplitude élevée. Lorsque la condition du mode à fuite est remplie pour la couche 4, il y a un apport constructif de l'onde incidente réfractée dans la couche 4 au mode à fuite 22 se propageant dans cette couche. De fait, la résonance correspond à une interférence positive entre l'onde réfractée puis réfléchie 32 se propageant dans la couche 4 et l'onde incidente réfractée en tout point d'impact sur cette couche. Ainsi, on obtient une accumulation d'énergie dans la couche 4 qui provient de la résonance décrite ici. Cette énergie sort partiellement selon la direction de réflexion 28 et partiellement selon la direction de diffraction 26. Etant donné que l'onde à fuite 22 présente une amplitude élevée, les présents inventeurs ont démontré qu'il est possible, en sélectionnant correctement la profondeur $\sigma$ du réseau de diffraction 8, de compenser l'amplitude élevée de l'onde réfléchie initialement par l'onde sortant de la couche 4 selon la direction de réflexion 28. Il se trouve que la condition d'excitation d'un mode à fuite sur la base de l'onde réfractée 32 engendre une onde sortant de la couche 4 (correspondant au rayon optique 28A) avec un déphasage de $\Pi$ relativement à l'onde réfléchie initialement (correspondant au rayon optique 28).

En résumé, on comprend que le concept inventif consiste à exciter dans la couche 4 un mode à fuite (onde à fuite 22) servant d'accumulateur d'énergie et à déterminer la profondeur $\sigma$ du réseau de diffraction 8 de manière à définir l'amplitude de l'onde sortant de la couche 4 selon la direction de réflexion 28 pour qu'elle soit sensiblement égale à l'amplitude de l'onde réfléchie. Ainsi, pour une onde incidente 20 donnée, il est possible de sélectionner une hauteur H de la couche 4 et une profondeur $\sigma$ du réseau de diffraction 8 pour obtenir une interférence destructive selon la direction de réflexion 28 et donc une très haute efficacité de diffraction selon la direction de diffraction 26. Théoriquement, il est possible d'obtenir une efficacité de diffraction de 100 % pour autant que le dispositif de diffraction n'absorbe pas d'énergie lumineuse.

Afin de schématiser au mieux le concept inventif décrit ci-avant, il a été représenté à la figure 3 par divers vecteurs les ondes essentielles à la description du phénomène physique mis en oeuvre dans le cadre de la présente invention. L'onde incidente 20 arrive sous un angle d'incidence complémentaire $\alpha$ sur le réseau de diffraction 8. Cet événement initial engendre une onde diffractée 24B, une onde réfléchie 30B et une onde à fuite 22 se propageant dans la couche 4 selon un mode à fuite excité par l'onde réfractée dans la couche 4. L'onde à fuite 22 sort de la couche 4 dans le milieu d'incidence essentiellement selon la direction de réflexion 28 et selon la direction de diffraction 26 définissant l'angle de diffraction $\varepsilon_c$. Ainsi, l'onde à fuite 22 engendre une onde 30A se propageant parallèlement à l'onde 30B et une onde diffractée 24A se propageant parallèlement à la direction de l'onde 24B.

Les divers paramètres caractéristiques du dispositif de diffraction selon l'invention sont déterminés de manière à ce que l'amplitude de l'onde 30B soit proche de l'amplitude de l'onde 30A ou égale à celle-ci. Le déphasage entre les ondes 30A et 30B étant sensiblement égal à $\Pi$, il en résulte une interférence destructive diminuant fortement ou annulant l'intensité lumineuse se propageant selon la direction de réflexion. Par contre, les ondes diffractées 24A et 24B interfèrent constructivement et définissent ainsi une direction de propagation pour l'énergie lumineuse renvoyée par le dispositif de diffraction. Par souci de précision, on notera que l'onde 24B correspond aux contributions conjointes des rayons optiques 26 et 38 de la figure 2 et que l'onde 30B correspond aux contributions conjointes des ondes correspondant aux rayons optiques 28 et 40 de cette figure 2. Pour les raisons mentionnées ci-avant, $\alpha$ ne définit pas l'angle complémentaire de $\varepsilon_c$ sur $\Pi/2$, la direction de diffraction étant différente de la direction d'incidence.

La condition d'excitation d'un mode à fuite dans la couche diélectrique 4 est donnée pour une couche avec ses faces inférieures et supérieures sensiblement planes par l'équation caractéristique :

$$KH(n_f^2 - n_c^2 \cos^2\alpha)^{1/2} = m\Pi - \varphi/2$$

où        $K = 2\Pi/\lambda$, $\lambda$ étant la longueur d'onde de fonde incidente,

- $n_c$ est l'indice de réfraction du milieu de propagation de l'onde incidente;
- $n_f$ est l'indice de réfraction de la couche diélectrique 4;
- $\alpha = \Pi/2 - \theta_c$, $\theta_c$ étant ledit angle d'incidence de l'onde incidente;
- $m$ est un nombre entier naturel; et
- $\varphi$ est le déphasage engendré par la réflexion de l'onde transmise sur la structure réfléchissante.

Lorsque le réseau de diffraction est de faible profondeur, la face supérieure 6 de la couche 4 est relativement peu perturbée et l'équation caractéristique susmentionnée reste essentiellement valable. Par contre, lorsque le réseau de diffraction présente une profondeur relativement grande, cette équation donne seulement une première approximation et il est nécessaire d'utiliser ensuite des outils informatiques appropriés pour déterminer précisément la hauteur H de la couche 4 correspondant précisément à l'excitation d'un mode à fuite en partant pour la calculation de la valeur donnée pour la hauteur par cette équation, ce que l'homme du métier saura faire. Toutefois, dans le cadre d'un mode de réalisation préféré où l'onde incidente présente un angle d'incidence $\theta_c$ relativement grand, plus particulièrement sensiblement égal à 85° ou supérieur à cette valeur, la profondeur du réseau de diffraction dans la cadre de la présente invention est relativement peu profond, ce qui a pour conséquence que l'équation caractéristique ci-dessus est sensiblement valable.

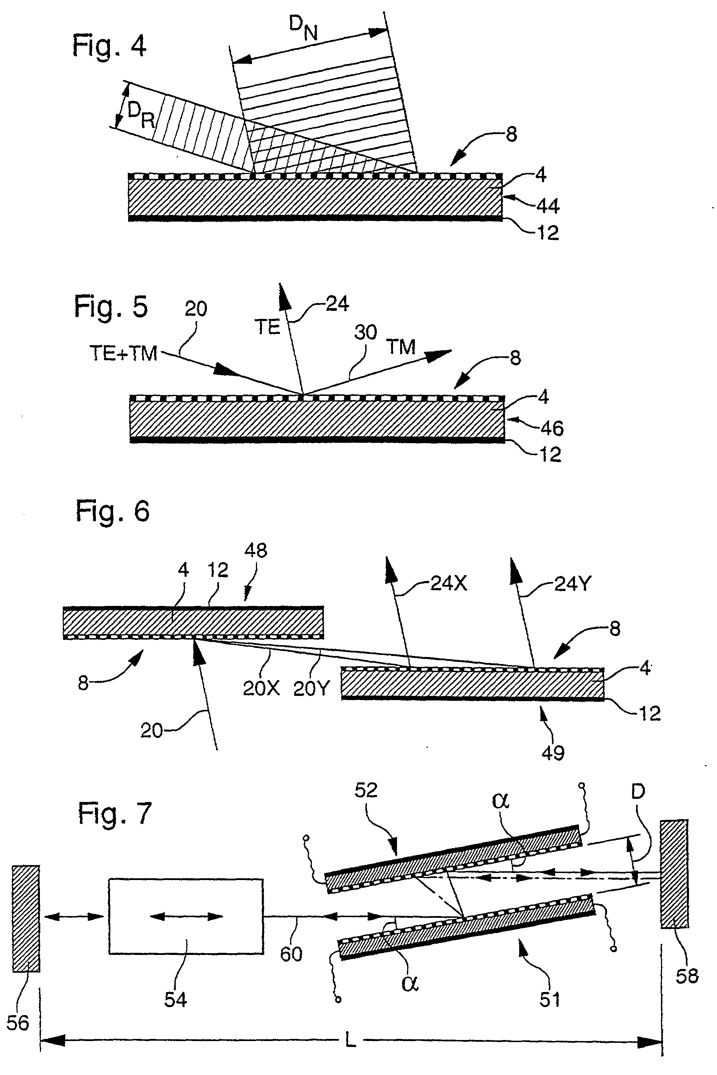

Pour certaines applications, il est particulièrement intéressant d'être en incidence rasante, notamment avec un angle d'incidence $\theta_c$ supérieur ou égal à 88°. En particulier, le dispositif de diffraction peut servir d'expanseur de faisceaux comme cela est représenté à la figure 4 sur laquelle le faisceau incident de diamètre $D_R$ est réfléchi selon une direction proche de la direction normale au réseau de diffraction 8 avec un diamètre $D_N$ fortement agrandi. Plus l'incidence est rasante, plus l'expansion est forte.

On notera que l'onde incidente peut présenter une polarisation transversale électrique TE ou transversale magnétique TM relativement à la direction définie par les lignes du réseau de diffraction. Dans le cas d'une polarisation TE (champ électrique parallèle aux lignes du réseau) et avec une incidence rasante, les inventeurs ont déterminé une expression analytique permettant de sélectionner la profondeur $\sigma$ du réseau de diffraction 8 de manière analytique pour une efficacité de diffraction très élevée et théoriquement proche de 100 % (cas où la structure réfléchissante 12 réfléchit quasi la totalité de l'énergie lumineuse). L'expression analytique pour la profondeur $\sigma$ est la suivante :

$$\sigma = \frac{4}{K} \cdot \frac{(\sin\alpha \cdot n_c)^{1/2}}{(n_f^2 - n_c^2\cos^2\alpha)^{1/2} \cdot (n_f^2 - n_c^2)^{1/2}} \cdot$$

$$\cdot \left[1 + \left(\frac{n_f\cos^\varepsilon_f}{n_c\cos^\varepsilon_c} \text{tg}(KHn_f\cos^\varepsilon_f + \psi/2)\right)^2\right]^{1/2}$$

Les paramètres caractéristiques déjà décrits intervenant dans l'expression analytique ci-dessus, ne seront pas à nouveau décrits. Tous les autres paramètres sont donnés à la figure 2. $\theta_f$ est l'angle de réfraction de l'onde incidente 21 défini relativement à la direction normale au réseau 8. $\varepsilon_f$ est l'angle de diffraction relativement à ladite direction normale pour l'onde diffractée d'ordre "-1" se propageant dans la couche diélectrique 4 et $n_c$ est l'indice de réfraction du milieu incident. $\Psi$ est le déphasage à la réflexion sur ladite structure réfléchissante pour l'onde diffractée d'ordre "-1" dans ladite couche.

La condition pour le mode à fuite impose que $KHn_f = (m\pi - \varphi/2)/\cos\theta_f$.

On notera que $\varepsilon_f$ et $\varepsilon_c$ sont reliés par la loi de la réfraction. Il en va de même pour $\theta_c$ et $\theta_f$. Il est donc possible de formuler l'expression analytique ci-dessus à l'aide de $\varepsilon_c$ et $\theta_c$, à l'exclusion de $\varepsilon_f$ et $\theta_f$. L'homme du métier sait également mettre dans une telle formule $\theta_c$ au lieu de l'angle complémentaire $\alpha$.

Pour la hauteur moyenne H de la couche 4, on part du milieu de l'harmonique fondamentale du développement en série de Fourrier du profil du réseau de diffraction 8. La profondeur $\sigma$ est l'amplitude totale crête-à-crête de cette harmonique fondamentale. Partant du résultat analytique, l'homme du métier peut utiliser des outils informatiques pour déterminer $\sigma$ encore plus précisément afin d'obtenir réellement une très haute efficacité proche de 100 %.

Pour profiter au mieux des possibilités du dispositif de diffraction selon l'invention, les différents paramètres caractéristiques sont de préférence déterminés pour assurer une très haute efficacité de diffraction. En particulier, selon un mode de réalisation préféré, la profondeur du réseau de diffraction est déterminée de manière que l'efficacité de diffraction de ladite onde incidente dans la direction de diffraction d'ordre "-1" est sensiblement égale ou supérieure à 95 %.

En appliquant le théorème de réciprocité dans le cas d'une haute efficacité de diffraction selon l'ordre "-1", on conclut qu'il est possible d'avoir une onde incidente présentant une direction de diffraction d'ordre "-1" avec un angle de diffraction $\varepsilon_c$ relativement grand et notamment sensiblement égal ou supérieur à 85°. Ce résultat étonnant est notamment dû à l'excitation d'un mode à fuite dans la couche diélectrique 4 sur la base de l'onde diffractée d'ordre "-1" dans cette couche 4. Cette configuration particulière est avantageuse pour diverses applications. L'angle d'incidence est choisi supérieur à zéro, étant entendu que l'angle de diffraction est positif. Selon une variante avantageuse, la polarisation de l'onde incidente est transversale électrique TE. De préférence, les paramètres caractéristiques et en particulier la profondeur du réseau de diffraction sont déterminés de manière à ce que l'efficacité de diffraction soit sensiblement égale ou supérieure à 95 %.

On notera que l'excitation d'un mode à fuite dans la couche diélectrique du dispositif de diffraction selon l'invention est déterminante pour les deux modes de réalisation préférés susmentionnés où soit l'onde incidente présente un angle d'incidence $\theta_c$ d'environ 85° ou plus, soit l'angle de diffraction d'ordre "-1" est d'environ 85° ou plus. De fait, ces deux modes de réalisation préférés sont associés entre eux par le fait que le dispositif lui-même, dans une situation réciproque, est identique. Seules les directions d'incidence et de diffraction sont inversées. C'est donc l'orientation du dispositif relativement à une onde incidente qui détermine si on utilise le dispositif avec $\theta_c$ ou $\varepsilon_c$ supérieur à 80°.

On notera encore que l'analyse par le théorème de réciprocité est valable lorsque l'efficacité de diffraction selon une direction donnée (ordre "-1") est élevée. Théoriquement, elle est strictement valable seulement lorsqu'une seule onde diffractée est engendrée par le dispositif de diffraction, avec une efficacité de diffraction très proche ou égale à 100 %. Toutefois, pour une efficacité d'environ 95 %, la situation réciproque donne un résultat comparable pour l'efficacité de diffraction car les ondes négligées sont de très faible intensité. Toutefois, pour des efficacités de diffraction moins élevées, il n'est pas exclu que les efficacités de diffraction soient similaires pour les deux situations réciproques.

La structure réfléchissante du dispositif de diffraction est formée dans une première variante par un film métallique très peu absorbant (tout métal à faible perte à la longueur d'onde d'utilisation, notamment de l'ultraviolet au lointain infrarouge) ou par une simple surface réfléchissante séparant la couche 4 d'un milieu, notamment gazeux, ayant un indice de réfraction qui permet une réflexion quasi totale ou totale de l'onde à fuite déterminante. Dans une autre variante, cette structure est formée par une structure diélectrique multicouche de très haute réflectivité. Dans une autre variante encore, elle est formée par une seule couche diélectrique ayant un indice de réfraction sélectionné pour qu'au moins l'onde à fuite 22 (figures 1 à 3) subisse une réflexion totale ou quasi totale. Comme mentionné dans l'équation analytique donnant la hauteur H de la couche diélectrique 4 pour engendrer par une onde incidente un mode résonant dans cette couche 4, cette hauteur H dépend du déphasage à la réflexion sur la structure réfléchissante 12. Dans le cas d'un métal parfait, ce déphasage $\varphi$ est égal à zéro pour la polarisation TM et est égal à $\pi$ pour la polarisation TE. Ainsi, lorsque la condition d'excitation dudit mode résonant est satisfaite pour une polarisation TE, elle ne sera pas satisfaite pour la polarisation TM. En déterminant les paramètres caractéristiques du dispositif de diffraction 46 (figure 5) de manière à obtenir une efficacité de diffraction élevée pour la polarisation TE, ce dispositif 46 peut servir de séparateur de polarisation pour une onde incidente non polarisée. Ainsi, une onde incidente 20 présentant les deux polarisations TE et TM est diffractée avec une polarisation TE et réfléchie avec une polarisation TM, l'onde diffractée 24 ayant alors une polarisation TE et l'onde réfléchie 30 ayant alors une polarisation TM.

Cette fonction de polarisation est particulièrement intéressante dans l'ultra-violet où il n'existe pas de polariseurs satisfaisants. Ainsi, le dispositif 46 peut servir de polariseur, l'onde diffractée ayant une polarisation strictement TE ou TM.

L'équation caractéristique donnée pour satisfaire la condition de résonance d'un mode à fuite, s'écrit également ment

$$KHn_f\cos\theta_f = m\Pi - \varphi/2$$

Il ressort clairement de cette équation caractéristique que la condition de résonance pour un mode à fuite dans la couche diélectrique 4 dépend de l'indice de réfraction $n_f$ de cette couche 4. Ensuite, la condition de résonance d'un mode à fuite dépend également de la longueur d'onde $\lambda$ de l'onde incidente ($K = 2\pi/\lambda$).

Il ressort de ces considérations qu'il est possible, pour une hauteur H déterminée de la couche 4, de sélectionner la longueur d'onde de l'onde diffractée selon l'ordre "-1" en variant la valeur de l'indice de réfraction $n_f$ de la couche 4. A cet effet, il est prévu d'associer le dispositif selon l'invention à des moyens de variation de l'indice de réfraction $n_f$ de la couche diélectrique 4 de manière à permettre une sélection de la longueur d'onde de l'onde incidente satisfaisant à la condition d'excitation d'un mode à fuite. Par exemple, il est possible de varier l'indice de réfraction $n_f$ en variant la température de la couche 4. Un mode de réalisation particulièrement avantageux est obtenu par un agencement d'électrodes de part et d'autre de la couche 4, faite d'un matériau électro-optique, permettant d'engendrer un champ électrique dans cette couche pour faire varier l'indice de réfraction $n_f$ en fonction de l'amplitude du champ électrique engendré par ces électrodes. Ainsi, le dispositif selon l'invention sert de sélecteur de longueur d'onde ou de ligne spectrale à haute résolution pour l'onde diffractée sans effectuer aucun déplacement du dispositif de diffraction relativement à la source fournissant l'onde incidente sur ce dispositif.

Le dispositif de diffraction selon l'invention peut également servir de sélecteur de longueur d'onde à haute résolution dans la configuration d'un mode de réalisation préféré dans lequel l'onde diffractée présente un angle de diffraction $\varepsilon_c$ élevé alors que l'angle d'incidence $\theta_c$ est relativement peu élevé. Dans cette situation, la tolérance sur l'angle d'incidence $\theta_c$ est faible pour se trouver dans la condition de résonance. Ainsi, dans ce mode de réalisation, il est possible, pour un indice de réfraction $n_f$ donné, de sélectionner la longueur d'onde de l'onde diffractée en variant l'angle d'incidence. Comme la tolérance sur cet angle d'incidence est relativement faible pour l'excitation d'un mode à fuite, il est possible d'obtenir un sélecteur de longueur d'onde ou de ligne spectrale à haute résolution.

Comme $n_f \cos \theta_f = (n_f^2 - n_c^2 \cos^2 \alpha)^{1/2}$, la condition de résonance pour un mode à fuite dépend aussi de l'angle $\alpha = \pi/2 - \theta_c$, c'est-à-dire de l'angle d'incidence (ou dans le cas réciproque de l'angle de diffraction $\varepsilon_c$). La dépendance de l'équation caractéristique susmentionnée en fonction de a a pour conséquence que la tolérance est élevée pour $\alpha$ et en particulier pour une incidence rasante, alors que cette tolérance diminue et devient faible lorsque l'angle $\alpha$ augmente et devient grand. Il résulte de ces considérations que, lorsque $\alpha$ et $\varepsilon_c$ sont petits, une onde incidente présentant une certaine divergence ou convergence est diffractée sous l'angle $\varepsilon_c$ avec une divergence ou une convergence nettement plus faible. Cette propriété de tolérance relativement grande en l'angle $\alpha$ permet de réaliser un réseau de spectromètre ou de monochromateur de grande efficacité et de faible bruit de fond pour des ondes incidentes rasantes mal collimatées, ce qui est avantageux dans les zones du spectre où les sources de lumière disponibles ont une faible cohérence spatiale. La raison du faible bruit de fond est que tout le faisceau à analyser se propage dans la direction de la réflexion 30, sauf la tranche de spectre voulue, qui est extraite sensiblement perpendiculairement. De plus, le dispositif selon l'invention peut servir de collimateur pour un faisceau incident sous un angle d'incidence faible; ce qui correspond à un mode de réalisation préféré de l'invention.

Une propriété intéressante pour la spectroscopie du dispositif en incidence rasante selon l'invention est dans le grand nombre de lignes de réseau diffractant le faisceau incident de relative faible largeur, ce qui se traduit par une grande résolution spectrale (séparation angulaire) avec une haute efficacité de diffraction (voisine de 100%).

Les diverses propriétés mentionnées ci-avant du dispositif de diffraction selon l'invention permettent de nombreuses applications intéressantes. Ainsi, le dispositif de l'invention peut encore servir notamment de spectromètre à balayage de fente sans partie mobile ou de modulateur d'amplitude en faisant varier l'indice de réfraction $n_f$ de la couche diélectrique.

Une autre propriété intéressante du dispositif selon l'invention est celle de l'amélioration de la cohérence spatiale d'un rayonnement laser incident sur le réseau lorsque celui-ci est situé dans une cavité laser. Lorsqu'un large faisceau laser collimaté, incident sur le réseau sous un angle d'incidence $\varepsilon_c$, est diffracté sous un angle rasant, et que l'accumulation d'énergie est forte du fait que $\alpha$ est faible et que l'indice $n_f$ est grand, le mode à fuite se propage sur une grande distance et communique aux autres parties du faisceau diffracté sous l'angle $\alpha$ une information de phase. Un miroir de fermeture de la cavité laser, placé sur le chemin du faisceau diffracté, renvoie cette information de phase à une autre partie du faisceau laser incident dans le milieu actif du laser par chemin réciproque, ce qui a pour effet d'augmenter la cohérence spatiale de l'émission laser par homogénéisation de phase dans la section transverse, du faisceau laser.

A la figure 6 est représentée une application particulière utilisant deux dispositifs de diffraction 48 et 49. Le système représenté sur cette figure 6 permet de séparer spatialement des ondes présentant des longueurs d'ondes différentes mais proches. Pour un indice de réfraction $n_f$ donné, il est ainsi possible de séparer spatialement les longueurs d'ondes contenues dans un faisceau incident 20 se trouvant dans la bande spectrale étroite propre à exciter un mode à fuite utile. En prenant deux longueurs d'ondes proches l'une de l'autre, le dispositif 48 diffracte deux ondes 20X et 20Y correspondant respectivement aux deux longueurs d'ondes sous deux directions de diffraction différentes, mais proches. A l'aide du deuxième dispositif 49, lequel a son réseau de diffraction sensiblement parallèle au réseau du dispositif 48, il est possible de séparer de manière appréciable les ondes diffractées 24X et 24Y engendrées par la diffraction sur le dispositif 49 des ondes incidentes 20X et 20Y. Le système de la figure 6 permet d'effectuer une analyse spectrale du faisceau incident 20 avec une très haute résolution. Il est ainsi possible, à l'intérieur même de la plage de tolérance $\delta\lambda$ pour l'excitation d'un mode à fuite utile de séparer spatialement des longueurs d'ondes différentes.

Comme déjà mentionné précédemment, le dispositif selon l'invention, en particulier dans l'un des deux modes de réalisation préférés ($\alpha$ ou $\varepsilon_f$ petit), engendre soit une expansion importante du diamètre du faisceau incident, soit une réduction importante de ce diamètre, comme cela est représenté à la figure 4. Ainsi, le dispositif 44 peut être utilisé comme un expanseur de faisceaux ou, dans la situation réciproque, comme un réducteur de faisceaux. Dans ce dernier cas, la réduction de faisceau s'accompagne d'une multiplication correspondante du champ électrique. Ceci augmente notamment l'efficacité de l'effet non linéaire dans un matériau non linéaire, par exemple un cristal doubleur de fréquence optique, placé sur le chemin du faisceau réduit.

Une propriété intéressante d'un réseau en incidence rasante est de permettre à un faisceau relativement étroit d'être diffracté par un grand nombre de lignes de réseau et donc de procurer une grande résolution spectrale. Le dispositif selon l'invention permet d'obtenir une efficacité de diffraction voisine de 100% tout en augmentant la résolution spectrale par une réduction de l'angle $\alpha$. Cette propriété peut être utilisée dans une cavité laser à fréquence optique accordable en montage dit le Litman-Metcalf où un miroir pivotant est placé transversalement au faisceau diffracté 24 par un réseau de diffraction dans les conditions de la présente invention. L'axe de pivotement du miroir est parallèle aux lignes du réseau.

Dans cette mise en oeuvre, le milieu incident est l'air ou le vide. Une haute efficacité de diffraction sur un large domaine de longueur d'onde est obtenue par l'utilisation d'une couche de bas indice $n_f$, par exemple $SiO_2$ ou $MgF_2$.

Un large domaine de longueur d'onde peut aussi être obtenu, avec une légère baisse d'efficacité, par l'utilisation d'un miroir métallique comme l'or, l'argent ou l'aluminium. Par exemple, une efficacité de diffraction supérieure à 80% sur une domaine de longueur d'onde de 100nm centré sur la longueur d'onde de 1,55 $\mu$m est obtenue avec un miroir d'aluminium, une couche 4 d'épaisseur 200nm, d'indice de réfraction $n_f$ = 2.13, un angle $\alpha$ = 3°, une période de réseau de 0.95$\mu$m et un angle diffracté $\varepsilon_c$ = 39°. Ce résultat peut être transposé dans tout domaine de longueur d'onde. Cet exemple n'est que l'une des possibilités d'applications du dispositif selon l'invention dans un laser accordable en fréquence.

Une application particulièrement intéressante est représentée à la figure 7. Deux dispositifs de diffraction selon l'invention 51 et 52 sont agencés dans une cavité résonante d'un laser comprenant un milieu actif 54 et deux miroirs d'extrémité 56 et 58. Les deux dispositifs 51 et 52 sont associés à des moyens électriques de variation de l'indice de réfraction nf de leurs couches diélectriques respectives. En utilisant la propriété définie précédemment, il est possible de sélectionner avec une haute résolution la longueur d'onde de l'onde diffractée par ces deux dispositifs 51 et 52.

Pour un angle d'incidence $\alpha$ donné, une variation de l'indice de réfraction nf permet de sélectionner un seul mode résonant au sein de la cavité laser qui remplisse également la condition de résonance pour un mode à fuite utile à la diffraction. Une variation de la longueur d'onde de l'onde résonante 60 engendre une variation de l'angle de diffraction sur le dispositif 51. Comme le réseau de diffraction du dispositif 52 est agencé en face du réseau de diffraction du dispositif 51, l'onde incidente sur le dispositif 52 se trouve dans une situation réciproque de sorte que l'onde 60 est diffractée par ce dispositif 52 selon une direction de diffraction parallèle à la direction d'incidence de l'angle 60 arrivant sur le dispositif 51.

Pour de hautes efficacités de diffraction, on a vu que le théorème de réciprocité s'applique sensiblement correctement de sorte que l'on obtient une haute efficacité de transmission de l'onde résonante 60 par l'ensemble formé des deux dispositifs dans les deux sens de propagation pour une longueur d'onde satisfaisante à la condition d'excitation d'un mode à fuite dans cet ensemble.

En choisissant la distance D entre les deux réseaux de diffraction et la longueur L entre les deux miroirs 56 et 58, on obtient un résonateur accordable en fréquence sans déplacement ou rotation d'un élément de la cavité résonante, ce qui est très avantageux. On peut ainsi fournir des lasers multimodes avec sélection d'un mode quelconque parmi une pluralité de modes longitudinaux sans aucun élément mobile et sans saut de mode longitudinal lorsque la fréquence optique varie.

Cette propriété provient du fait que le chemin géométrique de l'onde résonante 60 varie lorsque la longueur d'onde λ varie puisque l'angle de diffraction varie en fonction de λ comme cela a été représenté schématiquement à la figure 6. L'homme du métier peut déterminer les valeurs de α, L et D qui conduisent à un nombre de longueurs d'onde sur le chemin optique dans la cavité résonante automatiquement constant pour les diverses longueurs d'ondes prévues. Dans cette application, on choisit α de préférence petit et une efficacité de diffraction très haute, si possible de quasi 100 %.

Finalement, on notera que tous moyens de diffraction équivalents à un réseau de diffraction peuvent être envisagés, notamment une variation périodique de l'indice de réfraction de la couche 4. De plus, le réseau ou les moyens équivalents de diffraction ne sont pas nécessairement agencés à la face supérieure de la couche 4, mais peuvent également l'être à la face inférieure au niveau de laquelle est prévue une réflexion étant donné que le faisceau incident et le faisceau diffracté sont situés du côté de la face supérieure de la couche 4. On notera encore que le milieu ne peut être formé par un solide ou un fluide liquide.

Une autre application intéressante de l'association de deux réseaux identiques parallèles 51 et 52 de la figure 7 sans la cavité laser est celle d'un filtre de longueur d'onde passe-bande de très bas bruit de fond où le deuxième réseau 52 rejette la diffusion (scattering en anglais) crée sur le premier réseau 51 ayant une autre direction que celle du faisceau diffracté ou ayant une autre longueur d'onde ou une autre polarisation que celles prescrites pour le filtre n'étant pas diffractées par le deuxième réseau dans la direction de sortie du filtre parallèle à la direction du faisceau d'entrée 60.

## Revendications

1. Dispositif de diffraction (44, 46, 48, 49, 51, 52) d'ondes lumineuses formé :

   - d'une couche (4) dans laquelle peuvent se propager des ondes lumineuses,
   - d'une structure ou surface réfléchissante (12) agencée au niveau d'une face inférieure (10) de ladite couche, et
   - d'un réseau de diffraction (8) ou de moyens de diffraction équivalents agencé(s) à une des deux faces de cette couche ou à l'intérieur de celle-ci sous la forme d'une modulation périodique de son indice de réfraction;

   **caractérisé en ce que**, pour une onde incidente qu'il est prévu de diffracter par ce dispositif et qui a une longueur d'onde ($\lambda$) donnée et un angle d'incidence ($\theta_c$) sur ladite couche prédéterminé et défini relativement à la direction normale à cette couche, la hauteur moyenne (H) de ladite couche satisfait sensiblement à la condition de résonance pour un mode à fuite de l'onde incidente réfractée dans cette couche, et **en ce que** ledit réseau ou lesdits moyens équivalents est/sont agencé(s) pour diffracter ladite onde incidente essentiellement selon le premier ordre négatif de diffraction et sous un angle de diffraction ($\varepsilon_c$) ayant une valeur différente d'une valeur sensiblement égale à celle dudit angle d'incidence.

2. Dispositif de diffraction selon la revendication 1, **caractérisé en ce que** ladite couche (4) est formée d'un matériau diélectrique et présente une hauteur moyenne H sélectionnée de manière que l'équation caractéristique d'un mode à fuite

$$KH(n_f^2 - n_c^2 \cos^2 \alpha)^{1/2} = m\Pi - \varphi/2$$

   est sensiblement satisfaite,
   où $K = 2\Pi/\lambda$,
   m est un nombre entier naturel,
   $n_c$ est l'indice de réfraction du milieu d'incidence où se propage ladite onde incidente,
   $n_f$ est l'indice de réfraction de ladite couche,
   $\alpha = \Pi/2 - \theta_c$, où $\theta_c$ est ledit angle d'incidence,
   $\varphi$ est le déphasage engendré par la réflexion sur ladite structure ou surface réfléchissante (12) d'une onde lumineuse se propageant dans ladite couche selon ledit mode à fuite.

3. Dispositif selon la revendication 1 ou 2, **caractérisé en ce que** la profondeur dudit réseau de diffraction lorsqu'il est agencé à l'une des deux faces de ladite couche ou ladite modulation périodique dudit indice de réfraction lorsque ce réseau est agencé à l'intérieur de cette couche est sélectionnée de manière que l'amplitude de l'onde sortant de ladite couche dans la direction de réflexion de ladite onde incidente soit proche de ou sensiblement égale à l'amplitude de l'onde réfléchie par cette couche, ces deux ondes présentant entre elles un déphasage sensiblement égal à n•π, n étant un nombre entier impair.

**4.** Dispositif de diffraction selon l'une des revendications 1 à 3, **caractérisé en ce que** la profondeur dudit réseau de diffraction ou ladite modulation périodique de l'indice de réfraction de ladite couche est sélectionnée de manière que l'efficacité de diffraction de ladite onde incidente dans une direction de diffraction correspondant audit angle de diffraction est sensiblement égal ou supérieur à 95 %.

**5.** Dispositif selon la revendication 3 ou 4, **caractérisé en ce que** ledit angle d'incidence ($\theta_c$) est supérieur à 80°, ledit angle de diffraction étant largement inférieur à cet angle d'incidence.

**6.** Dispositif de diffraction selon la revendication 5 où ledit réseau de diffraction est situé à une face supérieure de ladite couche, **caractérisé en ce que** la polarisation de ladite onde incidente est transversale électrique TE et **en ce que** ladite profondeur dudit réseau de diffraction est sélectionnée de manière que sa valeur σ satisfasse sensiblement l'égalité suivante :

$$\sigma = \frac{4}{K} \cdot \frac{(\sin\alpha \cdot n_c)^{1/2}}{(n_f^2 - n_c^2 \cos^2\alpha)^{1/2} \cdot (n_f^2 - n_c^2)^{1/2}} \cdot$$

$$\cdot [1 + (\frac{n_f \cos^\varepsilon_f}{n_c \cos^\varepsilon_c} \, tg(KHn_f \cos^\varepsilon_f + \psi/2))^2 \,]^{1/2}$$

où $\alpha = \Pi/2 - \theta_c$, $K = 2\Pi/\lambda$,
$n_f$ est l'indice de réfraction de ladite couche,
$n_c$ est l'indice de réfraction du milieu d'incidence,
H est la hauteur moyenne de ladite couche,
$\varepsilon_c$ est ledit angle de diffraction,
$\varepsilon_f = \arcsin (n_c \sin\varepsilon_c/n_f)$,
Ψ est le déphasage à la réflexion sur ladite structure ou surface réfléchissante pour l'onde diffractée d'ordre "-1" dans ladite couche.

**7.** Dispositif de diffraction selon la revendication 3 ou 4, **caractérisé en ce que** ledit angle de diffraction, défini relativement à la direction normale audit réseau de diffraction est supérieur à 80°, ledit angle d'incidence étant largement inférieur à cet angle de diffraction et supérieur à zéro.

**8.** Dispositif de diffraction selon la revendication 7, **caractérisé en ce que** la polarisation de ladite onde incidente est transverse électrique TE.

**9.** Dispositif de diffraction selon la revendication 7 ou 8, **caractérisé en ce que** la profondeur (σ) dudit réseau de diffraction (8) ou ladite modulation périodique de l'indice de réfraction de ladite couche est sélectionnée de manière que l'efficacité de diffraction de ladite onde incidente dans la direction de diffraction correspondant audit angle de diffraction est sensiblement égal ou supérieur à 95 %.

**10.** Dispositif de diffraction selon l'une des revendications précédentes, **caractérisé en ce que** ladite structure réfléchissante (12) est formée par film métallique de faible absorption.

**11.** Dispositif de diffraction selon l'une des revendications 1 à 9, **caractérisé en ce que** ladite structure réfléchissante (12) est formée par un miroir diélectrique multicouche de très haute réflectivité ou par une seule couche diélectrique ou **en ce que** ladite surface réfléchissante sépare ladite couche d'un milieu fluide notamment gazeux ayant un indice de réfraction sélectionné pour qu'au moins une onde à fuite (22) se propageant selon ledit mode à fuite dans ladite couche (24) subisse une réflexion quasi totale ou totale.

**12.** Dispositif de diffraction selon l'une des revendications précédentes, **caractérisé en ce qu'**il forme un sélecteur de longueur d'onde ou de ligne spectrale à haute résolution pour l'onde diffractée sous ledit angle de diffraction.

**13.** Dispositif selon la revendication 5, **caractérisé en ce qu'**il constitue un expanseur d'un faisceau lumineux incident dans la direction définie par ledit angle de diffraction.

**14.** Dispositif selon la revendication 13, **caractérisé en outre en ce qu'**il constitue un collimateur pour un faisceau lumineux incident lorsque ce dernier présente une divergence ou une convergence.

**15.** Dispositif selon la revendication 7 ou 8, **caractérisé en ce qu'**il constitue un réducteur du diamètre d'un faisceau incident dans la direction de diffraction définie par ledit angle de diffraction.

**16.** Dispositif selon la revendication 3 ou 4, **caractérisé en ce qu'**il constitue un comme séparateur de polarisation de ladite onde incidente, l'onde diffractée sous ledit angle de diffraction ayant une polarisation TE, respectivement TM, et l'onde réfléchie ayant une polarisation TM, respectivement TE.

**17.** Dispositif de diffraction selon l'une des revendications précédentes, **caractérisé en ce qu'**il est associé à des moyens de variation de l'indice de réfraction ($n_f$) de ladite couche (4) de manière à permettre une sélection de la longueur d'onde λ de l'onde incidente satisfaisant à ladite condition de résonance pour un mode à fuite.

**18.** Spectromètre comprenant un dispositif de diffraction selon l'une des revendications 1 à 6, agencé de manière que le faisceau lumineux incident arrive avec une incidence sensiblement rasante sur ladite couche de ce dispositif pour obtenir une grande résolution spectrale avec une haute efficacité de diffraction.

**19.** Système optique servant à séparer spatialement en fréquence ou à décomposer spectralement un faisceau incident formé par au moins deux ondes avec des fréquences optiques différentes mais proches, ce système comprenant un premier dispositif de diffraction (49) selon la revendication 5 ou 6 et un deuxième dispositif de diffraction (48) selon l'une des revendications 7 à 9.

**20.** Laser à fréquence optique accordable en montage de Littman-Metcalf comprenant dans sa cavité un dispositif de diffraction selon l'une des revendications 1 à 11.

**21.** Laser ajustable ou accordable en fréquence et comprenant au sein de sa cavité résonante, délimitée par deux miroirs d'extrémité (56, 58), deux dispositifs de diffraction (51, 52) chacun selon la revendication 17, les deux réseaux de diffraction de ces deux dispositifs étant situés l'un en regard de l'autre et étant sensiblement parallèles l'un à l'autre, lesdits moyens de variation de l'indice de réfraction ($n_f$) de ladite couche (4) de chacun de ces deux dispositifs permettant de varier conjointement l'indice de réfraction des deux couches respectives de ces deux dispositifs pour sélectionner un mode longitudinal quelconque pour l'onde résonante (60) parmi une pluralité de modes longitudinaux de fréquences optiques différentes pouvant être entretenus dans ladite cavité résonante.

**22.** Laser selon la revendication 21, **caractérisé en ce que** la longueur (L) de ladite cavité résonante, la distance (D) entre les deux réseaux de diffraction, la période spatiale (Λ) de ces deux réseaux et l'angle d'incidence (α) de ladite onde résonante sont sélectionnés de manière que la condition de résonance dans ladite cavité est obtenue automatiquement pour chacun de ladite pluralité de modes longitudinaux sans déplacement ou rotation d'un élément formant cette cavité.

**Patentansprüche**

**1.** Lichtwellen-Beugungsvorrichtung (44, 46, 48, 49, 51, 52), gebildet aus:

- einer Schicht (4), in der sich Lichtwellen ausbreiten können,
- einer reflektierenden Struktur oder Oberfläche (12), die auf Höhe einer unteren Fläche (10) der Schicht angeordnet ist, und
- einem Beugungsgitter (8) oder äquivalenten Beugungsmitteln, das (die) auf einer der beiden Flächen dieser Schicht oder in dieser in Form einer periodischen Modulation ihres Brechungsindex ausgebildet ist (sind);

**dadurch gekennzeichnet, daß** für eine einfallende Welle, die durch diese Vorrichtung gebeugt werden soll und eine gegebene Wellenlänge (λ) und einen vorgegebenen Einfallswinkel ($θ_c$) auf der Schicht, der in bezug auf die Normalenrichtung dieser Schicht definiert ist, besitzt, die mittlere Höhe (H) der Schicht im wesentlichen die Resonanzbedingung für einen Streumodus der in dieser Schicht gebrochenen einfallenden Welle erfüllt, und daß das Gitter oder die äquivalenten Mittel so beschaffen ist (sind), daß sie die einfallende Welle im wesentlichen in der ersten negativen Beugungsordnung und unter einem Beugungswinkel ($ε_c$) beugen, der einen Wert hat, der von einem Wert, der im wesentlichen gleich jenem des Einfallswinkels ist, verschieden ist.

**2.** Beugungsvorrichtung nach Anspruch 1, **dadurch gekennzeichnet, daß** die Schicht (4) aus einem dielektrischen Material gebildet ist und eine mittlere Höhe (H) aufweist, die in der Weise gewählt ist, daß die charakteristische

Gleichung eines Streumodus

$$KH(n_f^2 - n_c^2 \cos^2 \alpha)^{1/2} = m\pi - \frac{\varphi}{2}$$

im wesentlichen erfüllt ist,

wobei $K = 2\pi/\lambda$,

m eine natürliche ganze Zahl ist,

$n_c$ der Brechungsindex des Einfallsmediums ist, in dem sich die einfallende Welle ausbreitet,

$n_f$ der Brechungsindex der Schicht ist,

$\alpha = \pi/2 - \theta_c$, wobei $\theta_c$ der Einfallswinkel ist,

$\varphi$ die Phasenverschiebung ist, die durch die Reflexion an der reflektierenden Struktur oder Oberfläche (12) einer Lichtwelle, die sich in der Schicht längs des Streumodus ausbreitet, erzeugt wird.

3. Vorrichtung nach Anspruch 1 oder 2, **dadurch gekennzeichnet, daß** die Tiefe des Beugungsgitters dann, wenn es auf einer der beiden Flächen der Schicht angeordnet ist, oder die periodische Modulation des Brechungsindex, wenn das Gitter in dieser Schicht angeordnet ist, in der Weise gewählt ist, daß die Amplitude der Welle, die die Schicht in Reflexionsrichtung der einfallenden Welle verläßt, angenähert gleich oder im wesentlichen gleich der Amplitude der durch diese Schicht reflektierten Welle ist, wobei diese beiden Wellen zueinander eine Phasenverschiebung aufweisen, die im wesentlichen gleich $n \cdot \pi$ ist wobei n eine ungerade ganze Zahl ist.

4. Beugungsvorrichtung nach einem der Ansprüche 1 bis 3, **dadurch gekennzeichnet, daß** die Tiefe des Beugungsgitters oder die periodische Modulation des Brechungsindex der Schicht in der Weise gewählt ist, daß der Beugungswirkungsgrad der einfallenden Welle in einer dem Beugungswinkel entsprechenden Beugungsrichtung im wesentlichen gleich oder größer als 95 % ist.

5. Vorrichtung nach Anspruch 3 oder 4, **dadurch gekennzeichnet, daß** der Einfallswinkel ($\theta_c$) größer als 80° ist, wobei der Beugungswinkel weit unter diesem Einfallswinkel liegt.

6. Beugungsvorrichtung nach Anspruch 5, bei der sich das Beugungsgitter auf einer oberen Fläche der Schicht befindet, **dadurch gekennzeichnet, daß** die Polarisation der einfallenden Welle elektrisch transversal TE ist und daß die Tiefe des Beugungsgitters in der Weise gewählt ist, daß ihr Wert $\sigma$ die folgende Gleichheit im wesentlichen erfüllt:

$$\sigma = \frac{4}{K} \cdot \frac{(\sin \alpha \cdot n_c)^{1/2}}{\left(n_f^2 - n_c^2 \cos^2 \alpha\right)^{1/2} \cdot \left(n_f^2 - n_c^2\right)^{1/2}} \cdot \left[1 + \left(\frac{n_f \cos \varepsilon_f}{n_c \cos \varepsilon_c} tg\left(KHn_f \cos \varepsilon_f + \frac{\Psi}{2}\right)\right)^2\right]^{1/2}$$

wobei $\alpha = \pi/2 - \theta_c$, $K = 2\pi/\lambda$ ist

$n_f$ der Brechungsindex der Schicht ist,

$n_c$ der Brechungsindex des Einfallsmediums ist,

H die mittlere Höhe der Schicht ist,

$\varepsilon_c$ der Beugungswinkel ist,

$\varepsilon_f = \arcsin(n_c \sin\varepsilon_c/n_f)$,

$\Psi$ die Phasenverschiebung bei der Reflexion an der reflektierenden Struktur oder Oberfläche für die gebeugte Welle der Ordnung "-1" in der Schicht ist.

7. Beugungsvorrichtung nach Anspruch 3 oder 4, **dadurch gekennzeichnet, daß** der Beugungswinkel, der in bezug auf die Normalenrichtung des Beugungsgitters definiert ist, größer als 80° ist, wobei der Einfallswinkel weit unter diesem Beugungswinkel und größer als null ist.

8. Beugungsvorrichtung nach Anspruch 7, **dadurch gekennzeichnet, daß** die Polarisation der einfallenden Welle transversal elektrisch TE ist.

9. Beugungsvorrichtung nach Anspruch 7 oder 8, **dadurch gekennzeichnet, daß** die Tiefe ($\sigma$) des Beugungsgitters (8) oder die periodische Modulation des Brechungsindex in der Schicht in der Weise gewählt ist, daß der Beugungswirkungsgrad der einfallenden Welle in der dem Beugungswinkel entsprechenden Beugungsrichtung im wesentlichen gleich oder größer 95 % ist.

10. Beugungsvorrichtung nach einem der vorhergehenden Ansprüche, **dadurch gekennzeichnet, daß** die reflektierende Struktur (12) durch einen Metallfilm mit geringer Absorption gebildet ist.

11. Beugungsvorrichtung nach einem der Ansprüche 1 bis 9, **dadurch gekennzeichnet, daß** die reflektierende Struktur (12) durch einen dielektrischen Mehrschichtspiegel mit sehr hohem Reflexionsvermögen oder durch eine einzige dielektrische Schicht gebildet ist oder daß die reflektierende Oberfläche die Schicht von einem insbesondere gasförmigen Fluidmedium trennt, das einen Brechungsindex besitzt, der so gewählt ist, daß wenigstens eine Streuwelle (22), die sich im Streumodus in der Schicht (24) ausbreitet, einer Quasitotal- oder Totalreflexion unterliegt.

12. Beugungsvorrichtung nach einem der vorhergehenden Ansprüche, **dadurch gekennzeichnet, daß** sie eine Wellenlängen- oder Spektrallinien-Wähleinrichtung mit hoher Auflösung für die gebeugte Welle unter dem Beugungswinkel bildet.

13. Vorrichtung nach Anspruch 5, **dadurch gekennzeichnet, daß** sie eine Erweiterungseinrichtung für ein Lichtstrahlenbündel bildet, das in der durch den Beugungswinkel definierten Richtung einfällt.

14. Vorrichtung nach Anspruch 13, außerdem **dadurch gekennzeichnet, daß** sie einen Kollimator für ein einfallendes Lichtstrahlenbündel bildet, wenn dieses letztere eine Divergenz oder eine Konvergenz aufweist.

15. Vorrichtung nach Anspruch 7 oder 8, **dadurch gekennzeichnet, daß** sie eine Reduziereinrichtung für den Durchmesser eines Strahlenbündels bildet, das in der durch den Beugungswinkel definierten Beugungsrichtung einfällt.

16. Vorrichtung nach Anspruch 3 oder 4, **dadurch gekennzeichnet, daß** sie eine Trenneinrichtung für die Polarisation der einfallenden Welle bildet, wobei die unter dem Beugungswinkel gebeugte Welle eine Polarisation TE bzw. TM besitzt und die reflektierte Welle eine Polarisation TM bzw. TE besitzt.

17. Beugungsvorrichtung nach einem der vorhergehenden Ansprüche, **dadurch gekennzeichnet, daß** ihr Mittel für die Änderung des Brechungsindex ($n_f$) der Schicht (4) zugeordnet sind, so daß eine Auswahl der Wellenlänge ($\lambda$) der einfallenden Welle möglich ist, die die Resonanzbedingung für einen Streumodus erfüllt.

18. Spektrometer, der eine Beugungsvorrichtung nach einem der Ansprüche 1 bis 6 enthält und so beschaffen ist, daß das einfallende Lichtstrahlenbündel bei der Schicht dieser Vorrichtung mit streifendem Einfall ankommt, um eine hohe spektrale Auflösung mit hohem Beugungswirkungsgrad zu erhalten.

19. Optisches System, das der räumlichen Frequenztrennung oder der spektralen Zerlegung eines einfallenden Strahlenbündels dient, das durch wenigstens zwei Wellen mit verschiedenen, jedoch nahe beieinanderliegenden optischen Frequenzen gebildet ist, wobei dieses System eine erste Beugungsvorrichtung (49) nach Anspruch 5 oder 6 und eine zweite Beugungsvorrichtung (48) nach einem der Ansprüche 7 bis 9 umfaßt.

20. Laser mit abstimmbarer optischer Frequenz in Littmann-Metcalf-Montage, der in seinem Resonanzhohlraum eine Beugungsvorrichtung nach einem der Ansprüche 1 bis 11 enthält.

21. Laser mit einstellbarer oder abstimmbarer Frequenz, der in seinem Resonanzhohlraum, der durch zwei Endspiegel (56, 58) begrenzt ist, zwei Beugungsvorrichtungen (51, 52) jeweils nach Anspruch 17 enthält, wobei sich die beiden Beugungsgitter dieser beiden Vorrichtungen einander gegenüber befinden und zueinander im wesentlichen parallel sind, wobei die Mittel für die Veränderung des Brechungsindex ($n_f$) der Schicht (4) jeder der beiden Vorrichtungen die gemeinsame Veränderung des Brechungsindex der beiden entsprechenden Schichten dieser beiden Vorrichtungen ermöglichen, um eine beliebige longitudinale Mode für die Resonanzwelle (60) aus mehreren longitudinalen Moden mit verschiedenen optischen Frequenzen, die in dem Resonanzhohlraum unterhalten werden können, auszuwählen.

22. Laser nach Anspruch 21, **dadurch gekennzeichnet, daß** die Länge (L) des Resonanzhohlraums, der Abstand (D) zwischen den beiden Beugungsgittern, die räumliche Periode ($\Lambda$) dieser beiden Gitter und der Einfallswinkel ($\alpha$) der Resonanzwelle in der Weise gewählt sind, daß die Resonanzbedingung in dem Hohlraum automatisch für jede der mehreren longitudinalen Moden ohne Verschiebung oder Drehung eines diesen Hohlraum bildenden Elements erhalten wird.

**Claims**

1. Light wave diffraction device (44, 46, 48, 49, 51, 52) formed of

   - a layer (4) in which light waves can propagate,
   - a reflective structure or surface (12) arranged on one lower face (10) of said layer, and
   - a diffraction grating (8) or equivalent diffraction means arranged on one face of the two faces of said layer, or within the latter in the form of a periodic modulation of its refractive index;

   **characterised in that**, for an incident wave intended to be diffracted by this device and having a given wavelength ($\lambda$) and a predetermined angle of incidence ($\theta_c$) on said layer defined relative to the direction orthogonal to said layer, the mean height (H) of said layer substantially satisfies the resonance condition for a leaky mode of the incident wave refracted in this layer, and **in that** this grating or these equivalent diffraction means is/are arranged to diffract said incident wave essentially along the first negative order of diffraction and at an angle of diffraction ($\varepsilon_c$) having a different value from a value substantially equal to that of said angle of incidence.

2. Diffraction device according to claim 1, **characterised in that** said layer (4) is formed of a dielectric material and has a mean height H selected so that the characteristic equation of a leaky mode :

$$KH(n_f^2 - n_c^2 \cos^2 \alpha)^{1/2} = m\Pi - \varphi/2$$

   is substantially satisfied,
   where $K = 2\Pi/\lambda$,
   m is a natural integer number,
   $n_c$ is the refractive index of the incidence medium where said incident wave propagates,
   $n_f$ is the refractive index of said layer,
   $\alpha = \Pi/2 - \theta_c$, where $\theta_c$ is said angle of incidence,
   $\varphi$ is the phase shift generated by the reflection of the wave transmitted on said reflective structure or surface (12) of a light wave propagating in said layer along said leaky mode.

3. Device according to claim 1 or 2, **characterised in that** the depth of said diffraction grating when arranged at one of the two faces of said layer or said periodic modulation of said diffraction grating when said grating is arranged within said layer is selected so that the amplitude of the wave exiting said layer along the direction of reflection is close to or substantially equal to the amplitude of the wave reflected by this layer, both waves having a phase shift substantially equal to $n \cdot \Pi$, n being an odd integer.

4. Diffraction device according to any of claims 1 to 3, **characterised in that** the depth of said diffraction grating or said periodic modulation of said diffraction grating of said layer is selected so that the diffraction efficiency of said incident wave in a direction of diffraction corresponding to said angle of diffraction is substantially equal to or greater than 95%.

5. Device according to claim 3 or 4, **characterised in that** said angle of incidence ($\theta_c$) is greater than 80°, said angle of diffraction being significantly less than said angle of incidence.

6. Diffraction device according to claim 5 wherein said diffraction grating is arranged at an upper face of said layer, **characterised in that** the polarisation of said incident wave is TE transverse electrical and **in that** said depth of said diffraction grating is selected so that its value $\sigma$ substantially satisfies the following equality :

$$\sigma = \frac{4}{K} \cdot \frac{(\sin\alpha \cdot n_c)^{1/2}}{(n_f^2 - n_c^2 \cos^2 \alpha)^{1/2} \cdot (n_f^2 - n_c^2)^{1/2}} \cdot$$

$$\cdot [1 + (\frac{n_f \cos^{\varepsilon}_f}{n_c \cos^{\varepsilon}_c} \, tg(KHn_f \cos^{\varepsilon}_f + \psi/2))^2 \,]^{1/2}$$

where $\alpha = \Pi/2-\theta_c$, $K = 2\Pi/\lambda$,
$n_f$ is the refractive index of said layer,
$n_c$ is the refractive index of the incidence medium,
H is the mean height of said layer,
$\varepsilon_c$ is said angle of diffraction,
$\varepsilon_f = \arcsin(n_c\sin\varepsilon_c/n_f)$,
$\psi$ is the phase shift at the reflection on said reflecting structure or surface for the « -1 » order diffracted wave in said layer.

7.  Diffraction device according to claim 3 or 4, **characterised in that** said angle of diffraction, defined relative to the direction perpendicular to said diffraction grating is greater than 80°, said angle of incidence being significantly less than said angle of diffraction and greater than zero.

8.  Diffraction device according to claim 7, **characterised in that** the polarisation of said incident wave is TE transverse electrical.

9.  Diffraction device according to claim 7 or 8, **characterised in that** the depth ($\sigma$) of said diffraction grating (8) or said periodic modulation of said diffraction grating of said layer is selected so that the diffraction efficiency of said incident wave in the direction of diffraction corresponding to said angle of diffraction is substantially equal to or greater than 95%.

10.  Diffraction device according to any of the preceding claims, **characterised in that** said reflecting structure (12) is formed by a low absorption metal film.

11.  Diffraction device according to any of claims 1 to 9, **characterised in that** said reflecting structure (12) is formed by a multilayer dielectric mirror of very high reflectivity or by a single dielectric layer or **in that** said reflecting surface separates said layer from a fluid medium in particular a gaseous medium having a refractive index selected so that at least one leaky wave (22) propagating according to said leaky mode in said layer (24) undergoes total or almost total reflection.

12.  Diffraction device according to any of the preceding claims, **characterised in that** it forms a high resolution wavelength or spectral line selector for the wave diffracted at said angle of diffraction.

13.  Device according to claim 5, **characterised in that** it forms an expander for an incident luminous beam in the direction defined by said angle of diffraction.

14.  Device according to claim 13, **characterised in that** it forms a collimator for an incident luminous beam when the latter is divergent or a convergent.

15.  Device according to claim 7 or 8, **characterised in that** it forms a diameter reducer for an incident beam in the direction of diffraction defined by said angle of diffraction.

16.  Device according to claim 3 or 4, **characterised in that** it forms a polarisation separator for said incident wave, the wave diffracted at said angle of diffraction having respectively a TE or TM polarisation, and the reflected wave having respectively a TM or TE polarisation.

17.  Diffraction device according to any of the preceding claims, **characterised in that** it is associated with means for varying the refractive index ($n_f$) of said laser (4) so as to allow selection of the wavelength $\lambda$ of the incident wave satisfying said resonance condition for a leaky mode.

18.  Spectrometer including a diffraction device according to any of claims 1 to 6 arranged so that the incident luminous beam has a substantially grazing incidence on said layer of this device allowing a high spectral resolution with a high diffraction efficiency.

19.  Optical system used to separate spatially in frequency or to spectrally decompose an incident beam formed by at least two waves with different but close optical frequencies, this system including a first diffraction device (49) according to any of claims 3 to 6, and a second diffraction device (48) according to any of claims 7 to 9.

20. Litman-Metcalf tuneable optical frequency laser including in the cavity thereof a diffraction device according to any of claims 1 to 11.

21. Frequency adjustable or tuneable laser including at the heart of its resonant cavity, delimited by two end mirrors (56, 58), two diffraction devices (51, 52) each according to claim 17, the two diffraction gratings of these two devices being situated facing each other and being substantially parallel to each other, said refractive index ($n_f$) variation means of said layer (4) of each of these two devices allowing the refractive indices of the two respective layers of these two devices to be jointly varied to select for the resonant wave (60) any one longitudinal mode of a plurality of longitudinal modes of different optical frequencies able to be maintained in said resonant cavity.

22. Laser according to claim 21, **characterised in that** the length (L) of said resonant cavity, the distance (D) between the two diffraction gratings, the spatial period ($\Lambda$) of these two gratings and the angle of incidence ($\alpha$) of said resonant wave are selected so that the resonance condition in said cavity is automatically obtained for each of said plurality of longitudinal modes without moving or rotating an element forming said cavity.

Fig. 1

Fig. 2

Fig. 3

Fig. 4

$D_N$

$D_R$

8

4

44

12

Fig. 5

20

24

TE

TE+TM

30

TM

8

4

46

12

Fig. 6

4    12    48

24X    24Y

8

4

8

20X    20Y

12

20

49

Fig. 7

52

α

D

60

α

51

58

56

54

α

L